# FASCICULE DE BREVET EUROPEEN

(11) **EP 2 453 470 B1**
(45) Date de publication et mention de la délivrance du brevet: **07.12.2016**
(21) Numéro de dépôt: 11354065.2
(22) Date de dépôt: 09.11.2011
(51) Int. Cl.: H01L 21/306, B81B 1/00

(54) **Procédé de formation d'une structure multicouches**
Verfahren zum Formen einer Mehrschichtenstruktur
Method for forming a multi-layer structure

(30) Priorité: 10.11.2010 FR 1004405
(43) Date de publication de la demande: 16.05.2012
(73) Titulaire: Commissariat à l'Énergie Atomique et aux Énergies Alternatives, 75015 Paris (FR); STMicroelectronics (Crolles 2) SAS, 38920 Crolles (FR)
(72) Inventeur: Desplobain, Sébastien, 38420 Le Versoud (FR); Gaillard, Frederic-Xavier, 38500 Voiron (FR); Morand, Yves, 38000 Grenoble (FR); Nemouchi, Fabrice, 38430 Moirans (FR)
(74) Mandataire: Talbot, Alexandre

(56) Documents cités:
- US-A- 5 242 863
- US-B1- 6 399 410
- SANG-HO KIM ET AL: "The Fabrication of Thin-Film Bulk Acoustic Wave Resonators Employing a ZnO/Si Composite Diaphragm Structure Using Porous Silicon Layer Etching", IEEE ELECTRON DEVICE LETTERS, IEEE SERVICE CENTER, NEW YORK, NY, US, vol. 20, no. 3, 1 mars 1999 (1999-03-01), XP011018552, ISSN: 0741-3106

## Description

### Domaine technique de l'invention

L'invention est relative à un procédé de formation d'une structure multicouches sur un substrat, et plus particulièrement un procédé de formation d'une alternance de couches en silicium massif et de couches en silicium poreux.

### État de la technique

Les substrats comprenant une alternance de couches en matériaux semi-conducteurs permettent la formation de dispositifs microélectroniques avancés. L'article « Novel 3D intégration process for highly scalable Nano-Beam stacked-channels GAA (NBG) FinFETs with HfO2/TiN gate stack » (Ernst. T et al., Electron Devices Meeting, 2006, IEDM '06. International, pp.1-4) décrit par exemple la formation d'un transistor multicanaux à partir d'une structure multicouches silicium/silicium-germanium.

Cette structure est obtenue par épitaxies successives de couches en silicium (Si) et de couches en silicium-germanium (SiGe). Lors de la croissance d'une couche en SiGe sur une couche en Si, le paramètre de maille du silicium-germanium s'adapte à celui du silicium. Le silicium-germanium épitaxié est alors pseudomorphe, ce qui permet de conserver la structure cristalline d'une couche de silicium à l'autre.

Les couches en SiGe sont ensuite gravées latéralement et sélectivement par rapport aux couches en Si. Cette sélectivité est obtenue par une vitesse de gravure du silicium-germanium supérieure à celle du silicium. Le procédé de gravure utilisé est une gravure par plasma de tétrafluorure de carbone (CF₄).

Les cavités créées par la gravure du SiGe sont remplies de matériau diélectrique et de silicium polycristallin afin de former des grilles de transistor superposées.

Ce procédé permet ainsi la superposition de couches en silicium massif ayant la même orientation cristalline, espacées par des couches sacrificielles en sillicium-germanium.

Toutefois, la structure multicouches Si/SiGe est inadaptée à la formation de plusieurs dispositifs, notamment les systèmes micro-électromécaniques (MEMS), du fait de certaines contraintes dimensionnelles.

D'une part, les procédés de gravure du silicium-germanium ne permettent pas à la fois une vitesse de gravure élevée et une sélectivité élevée par rapport au silicium. Il en résulte une surgravure des couches en silicium et/ou une limitation sur la longueur des couches en SiGe.

D'autre part, l'épaisseur des couches en SiGe est limitée, ainsi que le nombre de périodes dans la structure. En effet, il est nécessaire de respecter une épaisseur maximale des couches en SiGe afin de préserver leur état pseudomorphe. Cette épaisseur maximale diminue lorsque la concentration en germanium augmente. Il n'est donc pas possible d'augmenter la concentration en germanium pour augmenter la vitesse de gravure ou la sélectivité.

La publication de Kim et al. (IEEE Electron Devices Letters, Vol. 20, No. 3, 1999) décrit la formation d'un empilement de couches n/n+/n dans un substrat de silicium. Une zone de la face arrière est dopée n+ et recouverte d'un contact en aluminium. Puis la couche n+ est exposée à un traitement anodique pour la rendre poreuse.

Le document US 5,242,863 décrit la réalisation d'une zone enterrée faiblement résistive qui est reliée à la surface d'un substrat au moyen de tranchées faiblement résistives. Le reste du substrat est protégé par un polysilicium hautement résistif lors de la transformation du matériau faiblement résistif en un matériau poreux par anodisation.

### Résumé de l'invention

On constate qu'il existe un besoin de prévoir un procédé de formation d'une structure multicouches adaptée à tout type de dispositifs.

Plus particulièrement, on souhaite disposer d'une structure multicouches comprenant un matériau sacrificiel pouvant être éliminé rapidement et sélectivement.

On tend à satisfaire ce besoin en prévoyant un procédé selon les revendications annexées.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- les figures 1 à 4 représentent une première série d'étapes d'un premier mode de mise en oeuvre d'un procédé de formation de structure multicouches selon l'invention,
- la figure 5 représente une variante de réalisation de l'étape de la figure 4 pour former un plot de contact électrique latéral,
- les figures 6 à 8 représentent une seconde série d'étapes du premier mode de mise en oeuvre,
- la figure 9 représente une variante de réalisation de l'étape d'anodisation de la figure 6,
- les figures 10 et 11 représentent des étapes d'un deuxième mode de mise en oeuvre d'un procédé de formation de structure multicouches selon l'invention, et
- la figure 12 représente un exemple de structure comprenant une alternance de couches obtenue à l'aide du procédé selon l'invention.

### Description d'un mode de réalisation préféré de l'invention

On envisage de former une structure multicouches comprenant au moins une couche en silicium massif et une couche en silicium poreux. Contrairement au silicium-germanium, le silicium poreux peut être gravé rapidement et avec une grande sélectivité par rapport au silicium massif.

Le silicium poreux est généralement obtenu par dissolution anodique, appelée également anodisation, d'un échantillon de silicium massif dans un électrolyte à base d'acide fluorhydrique (HF). L'échantillon de silicium est placé dans un bain électrochimique ayant une concentration en acide fluorhydrique comprise entre 1 % et 50 % environ. Un champ électrique est appliqué en disposant une première électrode (cathode) dans l'électrolyte et une seconde électrode (anode) en contact électrique avec l'échantillon. Ce contact peut être direct en appliquant l'électrode sur l'échantillon ou indirect, par exemple par l'intermédiaire d'un électrolyte. Dans certains cas, l'échantillon est exposé à un rayonnement lumineux pour permettre la réaction de dissolution.

L'anodisation du silicium résulte d'un équilibre entre le transport de masse dans l'électrolyte et le transport des porteurs de charge dans le silicium. La réaction de dissolution se produit à la surface du silicium en contact avec l'électrolyte en présence des ions F⁻ de l'électrolyte HF et de trous d'électrons dans le silicium. Le champ électrique permet d'acheminer les trous à l'interface silicium/électrolyte. La densité et le diamètre des pores varient en fonction de la nature de l'échantillon, en particulier de son type de dopage, de son niveau de dopage, de la concentration en acide fluorhydrique, de la densité de courant et des conditions d'illumination. Le taux de porosité obtenu varie entre 4 et 97 %.

Une structure multicouches en silicium poreux est décrite dans l'article « Investigation and design of optical properties of porosity supperlattices » (Berger et al., Thin Solid Films, 255, 1995, pp.313-316). Cette structure présente une alternance de couches en silicium poreux avec différentes densités de pores. Elle est obtenue par épitaxies successives de couches en silicium dopées de type P avec différentes concentrations en dopants suivies d'une anodisation. Toutefois, un tel procédé rend la structure entièrement poreuse.

Le procédé décrit ci-après emploie également l'anodisation pour rendre poreux du silicium. Il permet par contre de conserver une couche en silicium massif, cristallin, qui peut être utilisée dans un dispositif microélectronique. Pour cela, on réalise un empilement avec au moins une couche sensible et une couche insensible à l'anodisation. La couche sensible est ensuite gravée latéralement, en dirigeant le champ électrique dans le plan de la couche sensible.

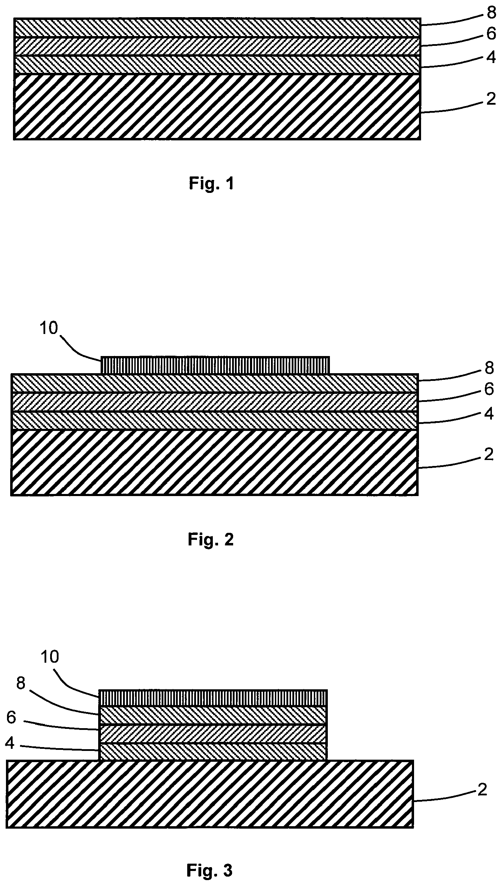

Les figures 1 à 4 représentent une première série d'étapes d'un mode de mise en oeuvre préférentiel d'un procédé de formation d'une structure multicouches Si massif/Si poreux.

La figure 1 représente un substrat 2 en silicium, par exemple dopé de type p, sur lequel est formé un empilement de couches. L'empilement comprend une couche 4 de blocage des trous d'électrons et deux couches 6 et 8 en silicium massif. Les couches 4, 6 et 8 sont, de préférence, formées par épitaxie. L'épaisseur de chacune des couches 4, 6 et 8 est comprise entre 10 nm et plusieurs micromètres, de préférence entre 10 nm et 100 nm.

Par couche 4 de blocage de trous d'électrons, on entend une couche limitant le transport des trous, et donc insensible à l'anodisation. Ainsi, la couche 4 pourra être un matériau électriquement isolant et résistant à l'acide fluorhydrique, un semi-conducteur intrinsèque ou un semi-conducteur dopé de type N avec une concentration en éléments dopants inférieure à 10¹⁸ atomes/cm³. Le principe consiste à utiliser une couche 4 ayant une concentration en trous suffisamment faible pour que celle-ci soit insensible à l'anodisation.

La couche 4 et la couche 8 sont, de préférence, des matériaux de même nature, par exemple un silicium dopé de type N avec une concentration en éléments dopants inférieure à 10¹⁸ atomes/cm³. Dans le cas d'un substrat 2 de type N, la couche 4 pourra faire partie intégrante du substrat 2.

On souhaite rendre poreux uniquement le silicium de la couche 6. La couche 6 peut alors être dopée de type P, de préférence avec une concentration en éléments dopants (atomes accepteurs : Bore) supérieure à 10¹⁵ atomes/cm³. Ainsi, les porteurs de charge sont majoritairement les trous, nécessaires à la réaction de dissolution.

Une couche 6 dopée de type N avec une concentration en éléments dopants (atomes donneurs: phosphore, arsenic) supérieure ou égale à 10¹⁸ atomes/cm³ peut également être utilisée. Par la suite, on appellera silicium de type N fortement dopé un silicium dopé de type N avec une concentration supérieure ou égale à 10¹⁸ atomes/cm³.

La concentration à 10¹⁸ atomes/cm³ semble être une concentration limite entre un silicium dopé N sensible à l'anodisation et un silicium dopé N insensible à l'anodisation. Cette concentration limite ayant été déterminée expérimentalement, elle peut varier en fonction des conditions de réalisation, le principe étant d'utiliser une concentration en trous suffisamment élevée pour rendre une couche sensible à l'anodisation.

A l'inverse, la couche 8 est destinée à former la couche en silicium massif dans la structure finale. Elle est donc de préférence laissée intacte lors de l'anodisation. Le silicium de la couche 8 et celui de la couche 6 sont donc de natures différentes, soit au niveau du dopage (éléments dopants de type opposé ou non dopé), soit au niveau de la concentration en dopants. La couche 8 peut être un silicium dopé de type N avec une concentration en éléments dopants inférieure à 10¹⁸ atomes/cm³ ou un silicium intrinsèque.

A la figure 2, un masque 10 de gravure est disposé sur la couche 8. Le masque 10 est, de préférence, en un matériau résistant à l'acide fluorhydrique, par exemple le nitrure de silicium. Un tel masque permet de définir un motif dans l'empilement.

La figure 3 représente l'étape de gravure des couches 4, 6 et 8 au travers du masque 10, par exemple par gravure plasma anisotrope. On délimite ainsi latéralement l'empilement, ce qui permet de réaliser ultérieurement un contact électrique dans la zone gravée.

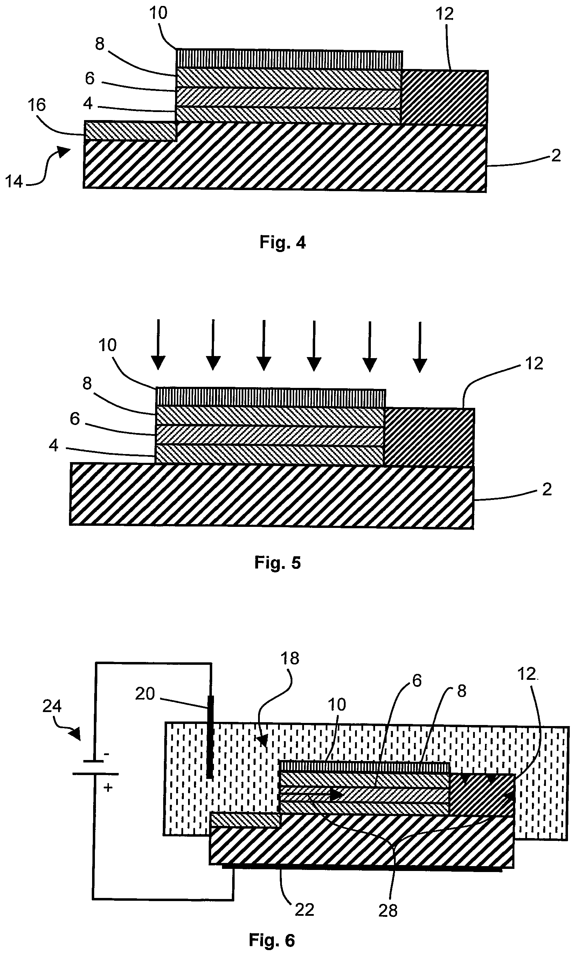

L'étape de la figure 4 correspond à la formation d'un plot de contact électrique 12 unilatéral sur le substrat 2, en contact avec la couche 6. Le contact 12 permet ainsi d'acheminer les trous du substrat 2 vers l'interface silicium/électrolyte, à gauche, en passant par la couche 6. De préférence, le contact 12 s'étend sur toute l'épaisseur des couches 4, 6 et 8. Le contact 12 peut être formé par le dépôt d'un métal, d'un siliciure ou d'un matériau semi-conducteur dopé de type P ou fortement dopé de type N, de préférence formé par épitaxie.

Une zone 14 du substrat 2, à gauche sur la figure 4, reste exposée. Cette zone risque donc d'être rendue poreuse si le substrat 2 est de type P. Dans ce cas, un caisson 16 de type N (concentration inférieure à 10¹⁸ atomes/cm³) peut être formé dans la zone 14 afin d'empêcher la réaction de dissolution. En d'autres termes, on rend la zone 14 insensible à l'anodisation.

On peut également envisager de déposer une couche de protection sur la zone 14 du substrat, de préférence une couche électriquement isolante et résistante au HF, ou de ne pas graver la couche 4 dans cette zone, lors de l'étape de la figure 3.

La figure 5 représente une variante de réalisation de l'étape de formation du plot de contact 12. Au lieu de déposer un matériau (Fig.4), le contact 12 peut être formé par implantation ionique au travers du masque 10. Les dopants implantés sont alors de type N en concentration supérieure ou égale à 10¹⁸ atomes/cm³ ou de type P.

Les figures 6 à 8 représentent une seconde série d'étapes du procédé de formation, après avoir défini l'empilement de couches requis et le contact 12.

L'étape de la figure 6 correspond au traitement électrochimique par dissolution anodique de la couche 6 en silicium, de type P ou de type N fortement dopé. La face avant du substrat 2, du côté de l'empilement, est immergée dans un électrolyte 18 à base d'acide fluorhydrique. Une électrode 20 est plongée dans l'électrolyte 18 et une électrode 22 est agencée de manière à polariser le substrat 2, par exemple sur la face arrière du substrat. Les électrodes 20 et 22 sont reliées à un générateur de tension 24. Ce traitement est réalisé sous obscurité.

Les électrodes 20 et 22 imposent un champ électrique global. La répartition du champ électrique dans la structure est telle que le déplacement des trous est privilégié dans les couches de type P (ou éventuellement couches N fortement dopées). Le déplacement des trous s'effectue donc préférentiellement dans le substrat 2, le contact 12, et dans la couche 6.

L'interface silicium/électrolyte, appelé également front de gravure, se déplace progressivement dans la couche 6 et éventuellement dans le contact 12 au fur et à mesure de la réaction, comme illustré par les flèches 28. Lorsque le contact 12 est en semi-conducteur de type P ou de type N fortement dopé, celui-ci est également attaqué chimiquement par l'électrolyte 18. Il en est de même pour un métal non inerte au HF. Le contact 12 est, de préférence, formé dans un métal insensible à l'anodisation choisi parmi Au, Pt ou Ag. Le front de gravure progresse alors dans une seule direction, dans le plan de la couche 6.

Bien que la couche 8 soit insensible à l'anodisation, il est préférable de couvrir celle-ci d'un matériau résistant à l'électrolyte 18. On élimine ainsi le risque d'une détérioration de la face supérieure de la couche 8, par exemple une augmentation de la rugosité de surface. Dans cette perspective, on conservera, de préférence, le masque de gravure 10 ayant servi à la délimitation de l'empilement et/ou à la formation du contact latéral 12.

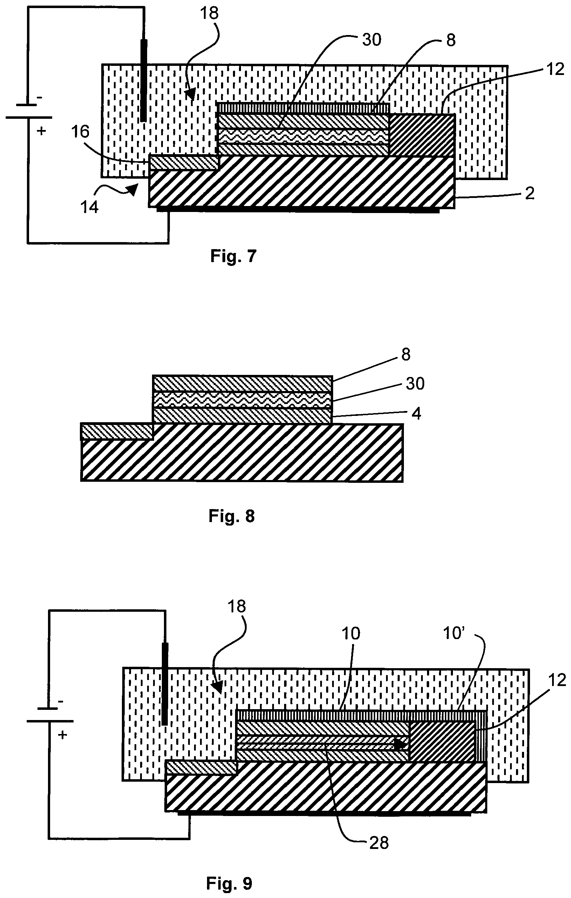

La figure 7 représente la structure obtenue à la fin de l'étape d'anodisation. La couche 6 de silicium massif est transformée en une couche 30 en silicium poreux. Le silicium 30 est, de préférence, microporeux ou mésoporeux.

Dans la zone 14, la surface du substrat 2 en contact avec l'électrolyte 18 reste intacte lorsqu'elle est protégée par une couche bloquante des trous, par exemple le caisson 16 de type N.

La figure 8 représente un exemple de structure multicouches obtenue par le procédé : une couche 8 de silicium massif disposée au-dessus d'une couche 30 en silicium poreux. Le contact 12 peut être éliminé, par exemple par gravure sèche avec une chimie chlorée ou par gravure humide avec une chimie iodée, au travers du masque 10. Le masque 10 peut également être retiré.

Dans le cas où les couches 6 et 8 de l'empilement sont formées par épitaxie à partir de la couche 4, par exemple en silicium dopé N, l'orientation cristalline de ces couches massives est conservée. En effet, le paramètre de maille est quasiment identique entre un dopage de type P (couche 6) et un dopage de type N (couches 4, 8). On évite ainsi les contraintes sur l'épaisseur de la couche 30 à sacrifier.

La figure 9 représente une variante de réalisation dans laquelle le contact latéral 12 est recouvert d'une couche de protection 10' en un matériau électriquement isolant et résistant à l'électrolyte 18. D'une part, le contact 12 est ainsi protégé contre l'anodisation, d'autre part, le chemin de déplacement des trous est modifié. Le front de gravure 28 se déplace uniquement au travers de la couche 6. Le matériau de la couche 10' est, de préférence, identique à celui du masque de gravure 10, par exemple le nitrure de silicium.

Dans le cas d'un contact 12 insensible à l'anodisation, par exemple en Au, Pt ou Ag, ou lorsque le contact est recouvert de la couche 10', la couche 6 est rendue poreuse quelle que soit sa longueur.

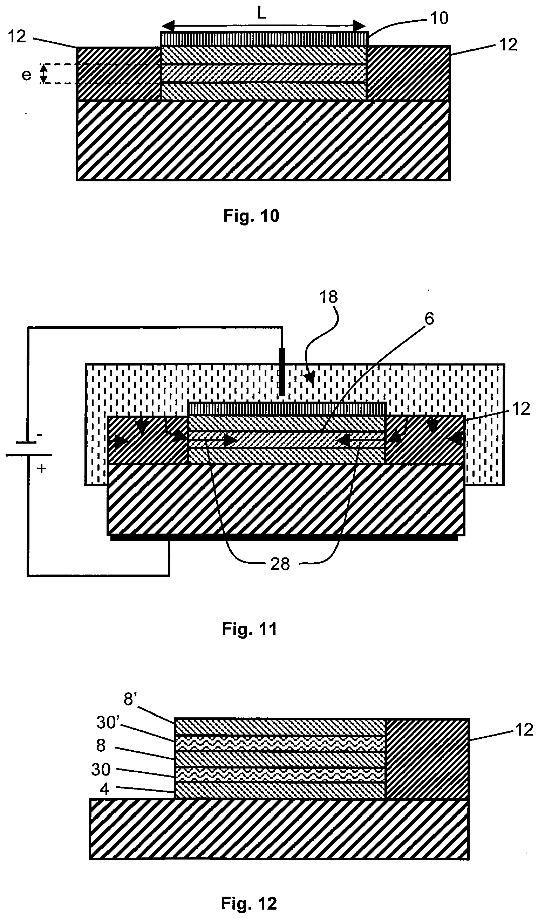

Les figures 10 et 11 représentent des étapes d'un second mode de mise en oeuvre d'un procédé de formation d'une structure multicouches.

A la figure 10, le contact électrique 12 est formé de chaque côté de l'empilement, c'est-à-dire sur des faces latérales opposées. Dans ce cas, le matériau formant le contact 12 est un matériau sensible à l'anodisation, par exemple un semi-conducteur dopé P ou fortement dopé N. Le contact bilatéral 12 peut être formé de la même manière que le contact unilatéral, comme cela a été décrit en relation avec les figures 3 à 5.

Ainsi, le contact 12 peut être présent sur une ou plusieurs faces latérales de l'empilement tant que la couche 6 peut rentrer en contact avec l'électrolyte. Dans certains cas, le contact peut être disposé à la périphérie de l'empilement.

La figure 11 représente l'étape suivante d'anodisation. Le principe de fonctionnement est similaire à celui décrit précédemment, en relation avec la figure 6. Dans cette configuration, le front de gravure 28 progresse de part et d'autre de l'empilement à travers le contact 12. Une portion supérieure du contact 12 est d'abord dissoute puis le front de gravure 28 atteint les deux extrémités de la couche 6 et progresse dans le plan de la couche 6.

Dans ce mode de réalisation, la longueur de la couche 6, notée L sur la figure 10, est fonction de l'épaisseur e de la couche. La longueur maximale qui peut être gravée est égale à environ deux fois l'épaisseur e (L=2.e). Au-delà de cette longueur maximale, le front de gravure n'atteint pas le centre de la couche 6. En effet, la portion du contact 12 à chaque extrémité de la couche 6 étant devenue poreuse, elle ne peut plus conduire les trous. Une partie centrale de la couche 6 ne sera donc pas convertie en silicium poreux. Toutefois, dans cette approche bilatérale, la distance gravée pour un temps donné est doublée.

Ce mode de réalisation permet donc de fixer la longueur à graver en fonction de l'épaisseur de la couche 6 indépendamment du temps gravure.

La figure 12 représente un autre exemple de structure multicouches comprenant une alternance de plusieurs couches en silicium poreux (30 et 30') avec plusieurs couches en silicium massif (8, 8'), c'est-à-dire plusieurs périodes Si/Si poreux. Cette structure est obtenue à l'aide du procédé décrit ci-dessus, en utilisant un contact latéral 12 qui s'étend sur toute la hauteur de l'empilement. Ainsi, plusieurs couches d'un même empilement peuvent être rendues poreuses simultanément. Les couches épitaxiées en silicium massif ont la même structure cristalline.

Le silicium poreux de la couche 30 (et de la couche 30' dans le cas de la figure 12) peut être conservé ou sacrifié selon les besoins de l'application visée.

Le silicium poreux peut être oxydé sélectivement par rapport au silicium massif. En effet, le silicium poreux avec des pores de quelques nanomètres ou dizaines de nanomètres (microporeux ou mésoporeux) présente une surface importante et des parois inter-pores de quelques nanomètres d'épaisseur seulement. Son oxydation thermique est donc plus rapide que celle du silicium massif. A titre d'exemple, des nanofils en silicium isolés électriquement entre eux par le silicium poreux oxydé peuvent être obtenus. En oxydant le silicium poreux, on évite les contraintes liées à la gravure du matériau sacrificiel et au remplissage par un oxyde.

L'oxyde de silicium poreux peut également être gravé sélectivement par rapport au silicium massif par gravure sèche ou par gravure humide à base d'acide fluorhydrique, par exemple pour réaliser localement une structure SON («Silicon On Nothing » en anglais). La couche de silicium massif peut même être contrainte (SSON : « Strained Silicon On Nothing ») en jouant sur l'épaisseur de la couche en silicium poreux et le temps d'oxydation.

Il est également possible de supprimer le silicium poreux sans avoir recours à une oxydation thermique, par exemple par gravure humide avec une solution de TMAH à température ambiante.

Dans le cas du silicium poreux ou de son oxyde, la vitesse de gravure et la sélectivité sont augmentées de manière significative par rapport au silicium-germanium. En particulier, dans le cas de silicium mésoporeux ou microporeux, la sélectivité et la vitesse de gravure sont augmentées d'au moins un ordre de grandeur. Ces matériaux sont donc particulièrement intéressants en tant que matériaux sacrificiels, par exemple pour la fabrication de poutres suspendues (« cantilevers » en anglais) dans les systèmes micro-électromécaniques (MEMS).

Enfin, une autre solution consiste à se placer en régime d'électropolissage (ou d'électroérosion) lors de l'anodisation, en appliquant un fort courant par exemple. Le silicium sensible à l'anodisation est alors gravé directement.

De nombreuses variantes et modifications du procédé décrit ici apparaîtront à l'homme du métier. Le procédé a été décrit en relation avec une structure multicouches en silicium. Il n'est pas exclu d'utiliser d'autres matériaux semi-conducteurs, notamment un alliage silicium-germanium avec une concentration en germanium inférieure à 30 %. Cet alliage présente des propriétés semblables à celle du silicium pur et peut être soumis à l'anodisation. En outre, le procédé n'est pas limité à des couches planes. Il peut être également appliqué à des couches aux formes variées. Dans tous les cas, il est possible de diriger le champ électrique vu par les trous en jouant sur l'empilement de couches conductrices et non-conductrices des trous.

## Revendications

1. Procédé de formation d'une structure multicouches sur un substrat (2), comprenant les étapes suivantes :
- prévoir le substrat recouvert par un empilement comprenant successivement une couche de blocage de trous d'électrons (4), une première couche (6) en matériau semi-conducteur dopé de type N ayant une concentration en éléments dopants supérieure ou égale à 10¹⁸ atomes/cm³ ou dopé de type P, et une deuxième couche (8) en matériau semi-conducteur de nature différente, la première couche (6) étant séparée du substrat (2) par la couche de blocage de trous d'électrons (4)
- délimiter latéralement l'empilement par gravure de la couche de blocage de trous d'électrons (4) et des première et deuxième couches (6,8) au travers d'un masque (10),
- réaliser un plot de contact électrique latéral (12) reliant la première couche (6) et le substrat (2),
- soumettre l'empilement à un traitement anodique dans un électrolyte (18) de manière à ce que le matériau de la première couche (6) soit transformé en matériau poreux (30) ou soit complètement gravé et à ce que la deuxième couche (8) soit insensible à l'anodisation.

2. Procédé selon la revendication 1, **caractérisé en ce que** la couche de blocage de trous (4) et la deuxième couche (8) sont formées dans un matériau semi-conducteur dopé de type N ayant une concentration en éléments dopants inférieure à 10¹⁸ atomes/cm³.

3. Procédé selon la revendication 1, **caractérisé en ce que** la deuxième couche (8) est en silicium intrinsèque.

4. Procédé selon l'une quelconque des revendications 1 à 3, **caractérisé en ce qu'**il comporte la formation d'une première couche de protection (10) en un matériau résistant à l'électrolyte (18) sur la deuxième couche (8) en matériau semi-conducteur.

5. Procédé selon la revendication 4, **caractérisé en ce qu'**il comporte la formation d'une deuxième couche de protection (10') en un matériau électriquement isolant et résistant à l'électrolyte (18) sur le plot de contact électrique latéral (12).

6. Procédé selon l'une quelconque des revendications 1 à 5, **caractérisé en ce que** le plot de contact électrique latéral (12) est formé par implantation ionique de type N avec une concentration en éléments dopants supérieure ou égale à 10¹⁸ atomes/cm³ ou de type P au travers du masque (10).

7. Procédé selon l'une quelconque des revendications 1 à 6, **caractérisé en ce que** le plot de contact électrique latéral (12) est formé par épitaxie d'un matériau semi-conducteur dopé de type N avec une concentration en éléments dopants supérieure ou égale à 10¹⁸ atomes/cm³ ou de type P.

8. Procédé selon l'une quelconque des revendications 1 à 6, **caractérisé en ce que** le plot de contact électrique latéral (12) est réalisé par dépôt d'une couche métallique.

9. Procédé selon l'une quelconque des revendications 1 à 8, **caractérisé en ce que** le plot de contact électrique latéral (12) est disposé de part et d'autre de l'empilement et **en ce qu'**il est formé dans un matériau semi-conducteur dopé de type N avec une concentration en éléments dopants supérieure ou égale à 10¹⁸ atomes/cm³ ou de type P.

10. Procédé selon la revendication 1, **caractérisé en ce que** l'empilement comprend une alternance de premières et deuxièmes couches (6, 8, 8') en matériaux semi-conducteurs.

## Patentansprüche

1. Verfahren zur Bildung einer Mehrschichtenstruktur auf einem Substrat (2), welches folgende Verfahrensschritte umfasst:
- es wird das Substrat vorgesehen, das von einer Packung bedeckt ist, welche aufeinanderfolgend eine Elektronenloch-Sperrschicht (4), eine erste Schicht (6) aus dotiertem Halbleiter-Material des Typs N mit einer Konzentration an Dotierungselementen von höher als oder gleich 10¹⁸ Atomen/cm³ oder des Typs P sowie eine zweite Schicht (8) aus Halbleiter-Material von anderer Art umfasst, wobei die erste Schicht (6) von dem Substrat (2) durch die Elektronenloch-Sperrschicht (4) getrennt ist,
- die Packung wird durch Ausstechen der Elektronenloch-Sperrschicht (4) und der ersten und der zweiten Schicht (6, 8) durch eine Maske (10) hindurch seitlich begrenzt,
- es wird ein seitlicher elektrischer Kontaktklotz (12) hergestellt, der die erste Schicht (6) und das Substrat (2) miteinander verbindet,
- die Packung wird einer anodischen Behandlung in einem Elektrolyt (18) dergestalt unterzogen, dass das Material der ersten Schicht (6) in ein poröses Material (30) umgewandelt wird oder vollständig ausgestochen wird, und dass die zweite Schicht (8) unempfindlich gegen die Anodisierung ist.

2. Verfahren nach Anspruch 1,
**dadurch gekennzeichnet,**
**dass** die Elektronenloch-Sperrschicht (4) und die zweite Schicht (8) aus einem dotierten Halbleiter-Material des Typs N mit einer Konzentration an Dotierungselementen von niedriger als 10¹⁸ Atomen/cm³ gebildet werden.

3. Verfahren nach Anspruch 1,
**dadurch gekennzeichnet,**
**dass** die zweite Schicht (8) aus eigenleitendem Silizium besteht.

4. Verfahren nach einem der Ansprüche 1 bis 3,
**dadurch gekennzeichnet,**
**dass** es die Bildung einer ersten Schutzschicht (10) aus einem Material, das widerstandfest gegen den Elektrolyt (18) ist, auf der zweiten Schicht (8) aus Halbleiter-Material umfasst.

5. Verfahren nach Anspruch 4,
**dadurch gekennzeichnet,**
**dass** es die Bildung einer zweiten Schutzschicht (10') aus einem elektrisch isolierenden Material, das widerstandfest gegen den Elektrolyt (18) ist, auf dem seitlichen elektrischen Kontaktklotz (12) umfasst.

6. Verfahren nach einem der Ansprüche 1 bis 5,
**dadurch gekennzeichnet,**
**dass** der seitliche elektrische Kontaktklotz (12) durch Ionenimplantation des Typs N mit einer Konzentration an Dotierungselementen von höher als oder gleich 10¹⁸ Atomen/cm³ oder des Typs P durch die Maske (10) hindurch gebildet wird.

7. Verfahren nach einem der Ansprüche 1 bis 6,
**dadurch gekennzeichnet,**
**dass** der seitliche elektrische Kontaktklotz (12) durch Epitaxie eines dotierten Halbleiter-Materials des Typs N mit einer Konzentration an Dotierungselementen von höher als oder gleich 10¹⁸ Atomen/cm³ oder des Typs P gebildet wird.

8. Verfahren nach einem der Ansprüche 1 bis 6,
**dadurch gekennzeichnet,**
**dass** der seitliche elektrische Kontaktklotz (12) durch Auftragen einer Metallschicht hergestellt wird.

9. Verfahren nach einem der Ansprüche 1 bis 8,
**dadurch gekennzeichnet,**
**dass** der seitliche elektrische Kontaktklotz (12) beiderseits der Packung angeordnet wird und dass er aus einem dotierten Halbleiter-Material des Typs N mit einer Konzentration an Dotierungselementen von höher als oder gleich 10¹⁸ Atomen/cm³ oder des Typs P gebildet wird.

10. Verfahren nach Anspruch 1,
**dadurch gekennzeichnet,**
**dass** die Packung abwechselnd angeordnete erste und zweite Schichten (6, 8, 8') aus Halbleiter-Materialen aufweist.

## Claims

1. A method for forming a multilayer structure on a substrate (2), comprising the following steps:
- providing the substrate (2) covered by a stack successively comprising an electron hole blocking layer (4), a first layer (6) made from N-doped semiconductor material having a dopant concentration greater than or equal to 10¹⁸ atoms/cm³ or P-doped semiconductor material, and a second layer (8) made from semiconductor material of different nature, the first layer (6) being separated from the substrate (2) by the electron hole blocking layer (4),
- laterally delineating the stack by etching the electron hole blocking layer (4) and the first and second layers (6 ,8) through a mask (10)
- making a lateral electric contact pad (12) connecting the first layer (6) and the substrate (2),
- subjecting the stack to anodic treatment in an electrolyte (18) such that the material of the first layer (6) is transformed into porous material (30) or is completely etched and such that the second layer (8) is insensitive to anodic treatment.

2. The method according to claim 1, **characterized in that** the hole blocking layer (4) and the second layer (8) are formed from N-doped semiconductor material having a dopant concentration less than 10¹⁸ atoms/cm³.

3. The method according to claim 1, **characterized in that** the second layer (8) is made from intrinsic silicon.

4. The method according to anyone of claims 1 to 3, **characterized in that** it comprises forming a first protective layer (10) made from a material resistant to the electrolyte (18) on the second layer (8) of semiconductor material.

5. The method according to claim 4, **characterized in that** it comprises forming a second protective layer (10') made from an electrically insulating material resistant to the electrolyte (18) on the lateral electric contact pad (12).

6. The method according to anyone of claims 1 to 5, **characterized in that** the lateral electric contact pad (12) is formed by ion implantation of N-type with a dopant concentration greater than or equal to 10¹⁸ atoms/cm³ or of P-type through a mask (10).

7. The method according to anyone of claims 1 to 6, **characterized in that** the lateral electric contact pad (12) is formed by epitaxy of an N-doped semiconductor material with a dopant concentration greater than or equal to 10¹⁸ atoms/cm³ or P-type semiconductor material.

8. The method according to anyone of claims 1 to 6, **characterized in that** the lateral electric contact pad (12) is made by deposition of a metal layer.

9. The method according to anyone of claims 1 to 8, **characterized in that** the lateral electric contact pad (12) is arranged on both sides of the stack and **in that** it is made from an N-doped semiconductor material with a dopant concentration greater than or equal to 10¹⁸ atoms/cm³ or P-type semiconductor material.

10. The method according to claim 1, **characterized in that** the stack comprises an alternation of first and second layers (6, 8, 8') made from semiconductor materials.
